**Europäisches Patentamt**

**European Patent Office**

**Office européen des brevets**

(19)

(11) Veröffentlichungsnummer : **0 155 393**
**B1**

(12) **EUROPÄISCHE PATENTSCHRIFT**

(45) Veröffentlichungstag der Patentschrift :
17.08.88

(51) Int. Cl.⁴ : **H 05 K   9/00**

(21) Anmeldenummer : **84115587.2**

(22) Anmeldetag : **17.12.84**

(54) **Hochfrequenzdichtung für Gehäuseverschlüsse und Türen.**

(30) Priorität : **01.03.84 DE 3407657**

(43) Veröffentlichungstag der Anmeldung :
**25.09.85 Patentblatt 85/39**

(45) Bekanntmachung des Hinweises auf die Patenterteilung : **17.08.88 Patentblatt 88/33**

(84) Benannte Vertragsstaaten :
**BE DE FR GB IT NL**

(56) Entgegenhaltungen :
**US-A- 3 240 862**
**US-A- 3 413 406**
**ELECTRONIC DESIGN, Band 27, Nr. 9, 26. April 1979,
Seiten 88-94; B. RASHKOW: "An EMI shield is only as
effective as its weakest link - the gasket"**

(73) Patentinhaber : **Siemens Aktiengesellschaft Berlin
und München**
**Wittelsbacherplatz 2**
**D-8000 München 2 (DE)**

(72) Erfinder : **Rogner, Ludwig, Dipl.-Ing.**
**Eigenheimweg 21a**
**D-8400 Regensburg (DE)**

## Beschreibung

Die Erfindung betrifft eine Hochfrequenzdichtung für Gehäuseverschlüsse, insbesondere Gehäusedeckel elektrischer Entstörgeräte, und für Türen hochfrequenzdicht abgeschirmter Räume, mit einer Entstördichtungsschnur, die teils aufgerolltes, streifenförmiges Metallgewebe enthält, das gegen die abzudichtenden Flächen anliegt.

Hochfrequenzdichtungen dieser Art sind durch die Firma Shielding Technologie, Inc. bzw. Chomerics, Inc. USA, unter der Bezeichnung Metalex Schnüre im Handel. Ihr z. B. aus Aluminium gefertiges, streifenförmiges Metallgewebe ist teils zu einer Hohlrolle aufgewickelt, deren Hohlraum mit plastischem oder elastischem Isoliermaterial oder mit einer spiralförmig gewickelten Rolle gefüllt ist, die bevorzugt aus dem gleichen Metallgewebe besteht.

Die DE-AS 23 28 951 beschreibt eine Hochfrequenzdichtung für Gehäuse, die ein schmiegsames elektrisch leitfähiges Band aufweist, in das plastisch schmiegsam ausgebildete magnetische bzw. magnetisierbare Mittel, insbesondere Permanentmagnete, eingeschlossen sind, wobei das Band von einem Metallgewebe umgeben ist.

Durch das DE-GM 17 86 047 ist eine Hochfrequenzdichtung bekannt, bei der zwischen einem Deckel und dem diesem gegenüberstehenden Rand eines Gehäuses eine quer elastische Zwischenlage als Abschirm-Verschluß für strahlungsdichten Abschluß des Gehäuses nach Aufbringung des Deckels vorgesehen ist, wobei im Gehäuse Hochfrequenzgeräte angeordnet sind, die keine Störabstrahlung in die Umgebung des Gehäuses hervorrufen sollen. Der Deckel muß mittels üblicher konstruktiver Maßnahmen auf das Gehäuse aufgedrückt und dort festgelegt werden, um einen beidseitigen metallischen Andruck gegen die quer-elastische Zwischenlage und damit die ohmsche Verbindung zwischen Deckel und Gehäuse sicherzustellen.

Die DE-PS 25 22 186 behandelt eine zwischen einem Gehäuse und einer Tür wirksame Hochfrequenzdichtung, mit einem Dichtungselement, das einen laschenartigen Fortsatz aufweist, der in eine Nut des Gehäuses oder der Tür mittels einer elastischen Leiste eingeklemmt ist. Das Dichtungselement weist einen runden elastischen Kern auf, der von einer leitenden Hülle umgeben ist. Der Kern und die Hülle des Dichtungselementes sind zwischen der elastischen Leiste und dem gegenüberliegenden Gehäuseteil angeordnet, so daß der Anpreßdruck anteilig vom Dichtungselement und der elastischen Leiste aufgenommen wird.

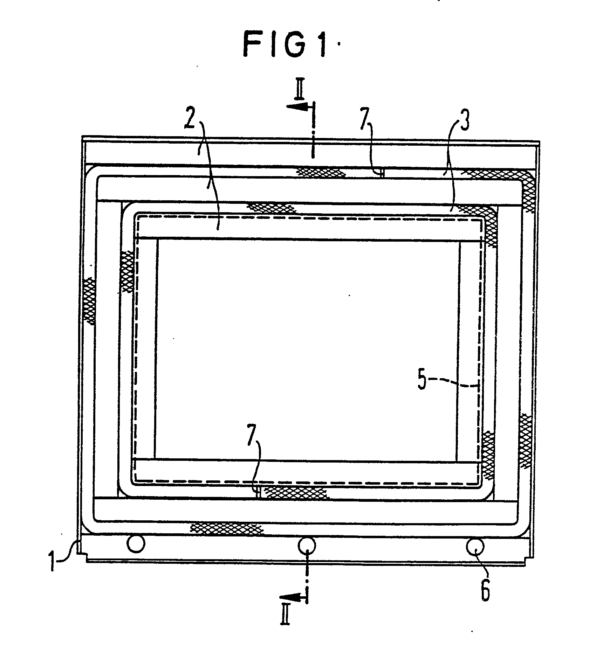

Schließlich ist — wie dies in Fig. 1 bis 3 dargestellt ist — eine Hochfrequenzdichtung für Gehäusedeckel für Metallgehäuse elektrischer Entstörfilter bekannt, die aus abwechselnd angeordneten Hochfrequenzdichtungsschnüren und Moosgummistreifen besteht, welch letzte auf das Gehäusedeckelinnere aufgeklebt sind. Die bei dieser bekannten Hochfrequenzdichtung auftretenden Nachteile sind im weiteren Verlauf der Beschreibung anhand der Figuren eingehender abgehandelt.

Der vorliegenden Erfindung liegt die Aufgabe zugrunde, eine Hochfrequenzdichtung der eingangs genannten Art zu schaffen, die raumsparend und bei einfacher Montage verschiebesicher auf die abzudichtenden Flächen aufgebracht werden kann.

Zur Lösung dieser Aufgabe sieht die Erfindung bei einer Hochfrequenzdichtung gemäß Oberbegriff des Patentanspruches 1 vor, daß die Entstördichtungsschnur mindestens zwei teils aufgerollte, streifenförmige Metallgewebe enthält, die mit ihren nicht aufgerollten Teilen übereinander und mit ihren aufgerollten Teilen bevorzugt Schlag an Schlag nebeneinander liegen und daß die Entstördichtungsschnur in ihren nicht aufgerollten Teilen punktweise auf die eine der abzudichtenden Flächen aufgeschweißt ist.

Durch diese Ausgestaltung und Anordnung der Hochfrequenzdichtung wird eine einwandfreie Abschirmung geschaffen. Bevorzugt sind dabei die nicht aufgerollten, quasi laschenartigen Ansätze punktweise über einen sogenannten Dichtdraht auf eine der abzudichtenden Flächen aufgeschweißt. Der Draht, der entsprechend der gewünschten Anordnung bzw. Ausrichtung der Entstördichtungsschnur geführt ist, gewährleistet eine verschiebesichere Befestigung der Entstördichtungsschnur selbst bei komplizierter Führung dieser Schnur.

Weitere Einzelheiten der Erfindung sind aus der Zeichnung ersichtlich. Es zeigt

Fig. 1 eine Unteransicht eines Gehäusedeckels, z. B. für ein elektrisches Filtergehäuse mit einer bekannten Hochfrequenzdichtung, und mit strichliniert angedeuteter Gehäuseöffnung.

Fig. 2 einen Schnitt gemäß der Linie 2'-2' nach Fig. 1, mit geschnittener und gebrochener Ansicht des Gehäuses.

Fig. 3 die Hochfrequenzdichtung nach Fig. 1 in der Darstellung nach fig. 1, jedoch mit teils aus ihren Befestigungen gelösten Moosgummistreifen und Dichtungsschnüren.

Fig. 4 in perspektivischer und schematischer Darstellung ein geeignetes Element für eine Entstördichtungsschnur nach der Erfindung.

Fig. 5 in der Darstellung nach Fig. 4 ein weiteres geeignetes Element für eine Entstördichtungsschnur nach der Erfindung.

Fig. 6 eine auf einen Gehäusedeckel aufgebrachte, aus den Elementen nach Fig. 4 oder 5 zusammengesetzte Entstördichtungsschnur nach der Erfindung in perspektivischer und teilweise gebrochener Darstellung.

Fig. 7 in der Darstellung nach Fig. 6 ein zweites Ausführungsbeispiel für die Befestigung einer Entstördichtungsschnur nach der Erfindung auf einem Gehäusedeckel.

Fig. 8 in der Darstellung nach Fig. 1 eine Unteransicht einer Hochfrequenzdichtung nach der Erfindung für einen Gehäusedeckel.

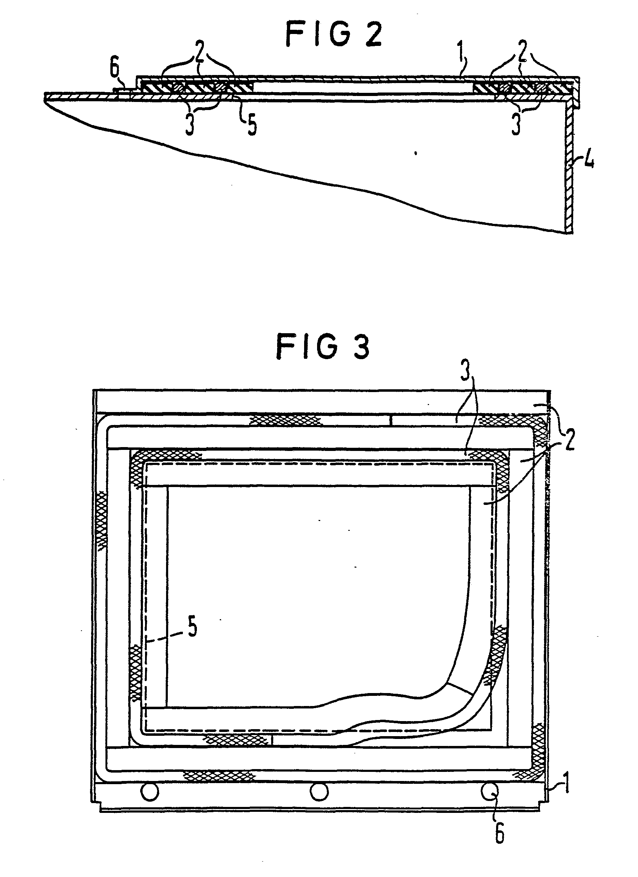

Beim bekannten Ausführungsbeispiel nach Fig. 1 bis 3 sind auf die Unterseite bzw. Innenfläche eines Gehäusedeckels 1, z. B. für ein Filtergehäuse 4 im Abstand zueinander angeordnete Moosgummistreifen 2 und Dichtungsschnüre 3 aufgeklebt und Dichtungsschnüre 3 zwischen die Moosgummistreifen geklemmt. Die Stroßstellen 7 der Dichtungsschnüre sind aus hochfrequenztechnischen Gründen auf gegenüberliegenden Seiten der strichliniert angedeuteten Gehäuseöffnung 5 eines in Fig. 2 gebrochen dargestellten Filtergehäuses 4 angeordnet.

Der Gehäusedeckel 1 besitzt zu seiner Schraubverbindung mit dem Filtergehäuse 4 längs seines einen Randes Bohrungen 6.

Die Dichtungsschnüre 3 sind z. B. aus elastischen Schnüren aus Isoliermaterial gefertigt, die mit einem schlauchförmigen Metallgewebe umhüllt sind.

Bei der Montage dieser Hochfrequenzdichtung muß außerordentlich genau gearbeitet werden. So darf beim Aufkleben der Moosgummistreifen 2 auf den Gehäusedeckel 1 der Kleber nicht unter die Dichtungsschnüre 3 geraten, da in diesem Fall die elektrische Verbindung zwischen dem Gehäusedeckel 1 und der Dichtungsschnur 3 unterbrochen ist. Bei mechanischer Beanspruchung des Filtergehäuses oder bei Fertigungsfehlern kann die Dichtungsschnur aus ihrer Lage « springen » (siehe Fig. 3), wodurch die Hochfrequenzdichtung ihre Dichtungseigenschaften verliert. Zudem können die lediglich zwischen die Moosgummistreifen 2 eingeklemmten Dichtungsschnüre 3 beim Abheben des Gehäusedeckels 1 herausfallen.

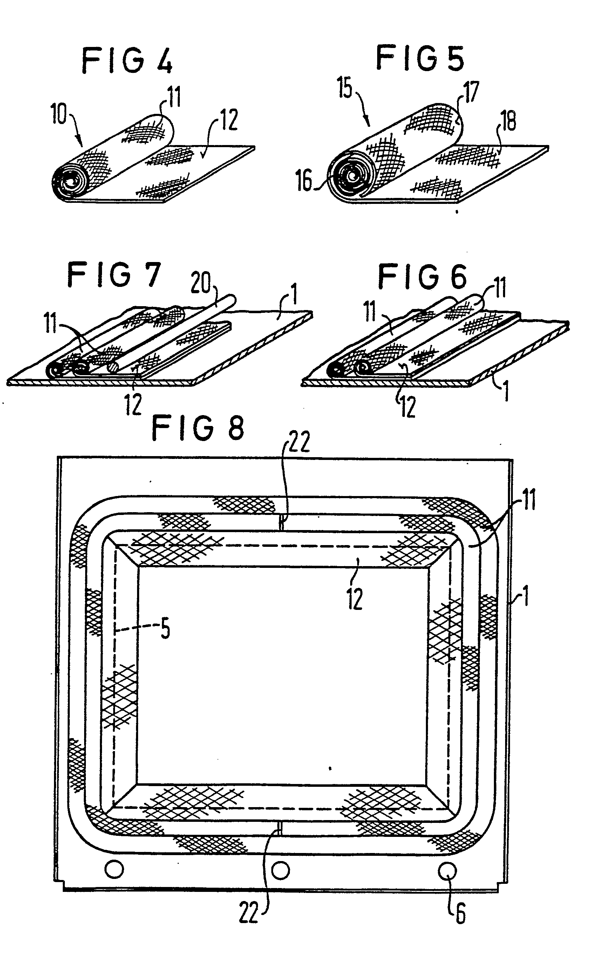

Im Unterschied zu den in der Hochfrequenzdichtung nach Fig. 1 bis 3 verwendeten Dichtungsschnüren 3 enthält die in Fig. 6 bis 8 dargestellte Entstördichtungsschnur nach der Erfindung Elemente 10 bzw. 15 (siehe Fig. 4 bzw. Fig. 5), aus teils aufgerollten streifenförmigen Metallgeweben. Mindestens zwei dieser Elemente 10 bzw. 15 sind dabei — wie dies in Fig.6 und 7 dargestellt ist — jeweils zu Entstördichtungsschnüren zusammengesetzt. Mit ihren nicht aufgerollten Teilen 12 bzw. 18 liegen die Elemente 10 bzw. 15 dabei übereinander und mit ihren aufgerollten Teilen 11 bzw. 16, 17 nebeneinander.

Das Element 10 nach Fig. 4 besteht aus einem teils spiralförmig aufgewickelten Metallgewebe. Beim Element 15 nach Fig. 5 ist dieses Metallgewebe teilweise zu einer Hohlrolle aufgewickelt, deren Inneres durch ein zweites spiralförmig gewickeltes Metallgewebe 16 oder einen elastischen, gegebenenfalls auch plastischen Kern aus Isolierstoff ausgefüllt ist.

Die Entstördichtungsschnur kann gemäß Fig. 6 mit ihren nicht aufgerollten Teilen 12 punktweise auf den Gehäusedeckel 1 aufgeschweißt sein. Sollten Probleme hinsichtlich der Festlegung der Entstördichtungsschnur bestehen, so kann zusätzlich ein Draht 20 (siehe Fig. 7) auf den nicht aufgerollten Teil 12 der Entstördichtungsschnur aufgelegt werden, der entsprechend der gewünschten Anordnung der Entstördichtungsschnur geführt und auf die darunterliegende Fläche des Gehäusedeckels 1 aufgeschweißt ist.

Zu beachten ist, daß jeweils das obenauf liegende Metallgewebe bzw. Element 10 bzw. 15 geringere Breite aufweist und daß die stoßstellen 22 der einzelnen Elemente sich auf gegenüberliegenden Seiten der Gehäuseöffnung 5 befinden.

## Patentansprüche

1. Hochfrequenzdichtung für Gehäuseverschlüsse, insbesondere Gehäusedeckel elektrischer Entstörgeräte, und für Türen hochfrequenzdicht abgeschirmter Räume, mit einer Entstördichtungsschnur, die teils aufgerolltes, streifenförmiges Metallgewebe enthält, das gegen die abzudichtenden Flächen anliegt, dadurch gekennzeichnet, daß die Entstördichtungsschnur mindestens zwei teils aufgerollte, streifenförmige Metallgewebe (10 bzw. 15) enthält, die mit ihren nicht aufgerollten Teilen (12 bzw. 18) übereinander und mit ihren aufgerollten Teilen (11 bzw. 16, 17) Schlag an Schlag nebeneinander liegen, und daß die Entstördichtungsschnur in ihren nicht aufgerollten Teilen (12 bzw. 18) punktweise auf die eine (1) der abzudichtenden Flächen (1, 4) aufgeschweißt ist.

2. Hochfrequenzdichtung nach Anspruch 1, dadurch gekennzeichnet, daß auf die übereinanderliegenden, nicht aufgerollten Teile (12 bzw. 18) der Entstördichtungsschnur ein Draht (20) aufgelegt ist, der entsprechend der gewünschten Anordnung der Entstördichtungsschnur geführt und auf die darunterliegende, abzudichtende Fläche (1) aufgeschweißt ist.

3. Hochfrequenzdichtung nach Anspruch 1, dadurch gekennzeichnet, daß das jeweils obenauf liegende Metallgewebe (10 bzw. 18) geringere Breite aufweist.

## Claims

1. A radio-frequency seal for housing closures, particularly for housing covers of electrical interference suppression devices, and for doors of radio-frequency-shielded rooms, comprising an interference suppression sealing cord which contains partly rolled-up strip-shaped metal fabric which rests against the surfaces to be sealed, characterised in that the interference suppression sealing cord contains at least two partly rolled-up strip-shaped metal fabrics (10 and 15 respectively) which are located with their unrolled parts (12 and 18) above one another and with their rolled parts (11 and 16, 17) next to one another turn against turn and that the interference suppression sealing cord is welded, at its unrolled parts (12 and 18), point by point onto one (1) of the surfaces (1, 4) to be sealed.

2. A radio-frequency seal according to Claim 1, characterised in that a wire, which is placed in accordance with the desired arrangement of the interference suppression sealing cord and is welded onto the underlying surface (1) to be sealed, is placed onto the unrolled parts (12 and 18, respectively) of the interference suppression sealing cord which are located above one another.

3. A radio-frequency seal according to Claim 1, characterised in that the metal fabric (10 or 18) located at the top in each case exhibits a lesser width.

**Revendications**

1. Joint formant barrage ou joint d'étanchéité aux hautes fréquences, pour fermetures de boîtiers, en particulier de couvercles de boîtiers d'appareils électriques d'antiparasitage; et pour portes de locaux à écran HF, comprenant une corde de garniture antiparasites qui contient de la toile mécanique en bande partiellement enroulée, laquelle est appliquée contre les surfaces à étanchéifier, caractérisé en ce que la corde d'étanchéité antiparasites contient au moins deux toiles métalliques (10 ou 15) en forme de bandes partiellement enroulées, qui sont superposées par leurs parties non enroulées (12 ou 18) et sont disposées jointives l'une à coté de l'autre par leurs parties enroulées (11 ou 16, 17), et que la corde d'étanchéité antiparasites est soudées par points, par ses parties non enroulées (12 ou 18), sur l'une (1) des surfaces (1, 4) à étanchéifier.

2. Joint selon la revendication 1, caractérisé en ce qu'un fil (20) est posé sur les parties superposées, non enroulées (12 ou 18) de la corde antiparasites, fil qui est guidé selon la disposition désirée de la corde et est soudé sur la surface (1) à étanchéifier sous-jacente.

3. Joint selon la revendication 1, caractérisé en ce que la toile métallique (10 ou 18) se trouvant en haut possède une plus faible largeur.

# FIG 1·

# FIG 2

# FIG 3

# FIG 4

# FIG 5

# FIG 7

# FIG 6

# FIG 8